# FASCICULE DE BREVET EUROPEEN

(11) **EP 3 675 187 B1**
(45) Date de publication et mention de la délivrance du brevet: **23.06.2021**
(21) Numéro de dépôt: 19219348.0
(22) Date de dépôt: 23.12.2019
(51) Int. Cl.: H01L 33/40, H01L 23/00, H01L 33/62, H01L 33/38

(54) **PROCÉDÉS DE FABRICATION OPTIMISÉS D'UNE STRUCTURE DESTINÉE À ÊTRE ASSEMBLÉE PAR HYBRIDATION ET D'UN DISPOSITIF COMPRENANT UNE TELLE STRUCTURE**
OPTIMIERTE HERSTELLUNGSVERFAHREN EINER STRUKTUR, DIE DURCH HYBRIDISIERUNG ZUSAMMENGEBAUT WERDEN SOLL, UND VORRICHTUNG, DIE EINE SOLCHE VORRICHTUNG UMFASST
OPTIMISED METHODS FOR MANUFACTURING A STRUCTURE TO BE ASSEMBLED BY HYBRIDISATION AND A DEVICE INCLUDING SUCH A STRUCTURE

(30) Priorité: 28.12.2018 FR 1874362
(43) Date de publication de la demande: 01.07.2020
(73) Titulaire: Commissariat à l'énergie atomique et aux énergies alternatives, 75015 Paris (FR)
(72) Inventeur: BERNARD, Jeannet, 38054 GRENOBLE CEDEX 09 (FR)
(74) Mandataire: Brevalex

(56) Documents cités:
- WO-A1-2006/054005
- WO-A1-2018/033689
- US-A1- 2013 328 013

## Description

### Domaine technique

L'invention concerne le domaine des dispositifs semiconducteurs et plus particulièrement les dispositifs optoélectroniques.

L'invention a ainsi plus précisément pour objet un procédé de fabrication d'une structure semiconductrice destinée à être assemblée par hybridation à un support et un procédé de fabrication d'un dispositif comprenant une structure et support auquel est assemblé ladite structure par hybridation.

### État de l'art antérieur

La fabrication de certains dispositifs semiconducteurs peut nécessiter une opération de connexion, par exemple par hybridation, d'une structure semiconductrice sur un support dédié. Cela est notamment le cas pour les dispositifs de l'optoélectronique pour lesquels ladite structure peut être réalisée dans un ou plusieurs matériaux semiconducteur dit III-V et le support est réalisé en silicium, ce dernier pouvant inclure un circuit de commande de ladite structure basé sur une technologie du type C-MOS.

Pour permettre une telle connexion par hybridation, il est connu, notamment des documents WO 2006/054005 et WO 2009/115686, de fournir la structure avec des inserts et le support avec des plots en matériau conducteur ductile, la connexion étant obtenue par insertion des inserts dans lesdits plots en matériau conducteur ductile.

La fabrication d'une structure adaptée pour une telle connexion, c'est-à-dire comprenant lesdits inserts, est généralement réalisée en plusieurs étapes collectives, permettant de fabriquer une pluralité de structure sur un même support, et avec des étapes d'individualisation comprenant notamment :
- la gravure localisée d'au moins une couche active dans laquelle est aménagée la région active de chacune des structures, cette gravure permettant d'isoler les régions actives entre elles de manière à former lesdites structures indépendamment les unes des autres, et
- une séparation de ces dites structures du substrat.

Or, lorsque l'au moins une couche active d'une telle structure comprend un matériau semiconducteur nitruré, tel que du nitrure de gallium, l'étape de gravure localisée de l'au moins une couche active doit nécessairement faire appel à un procédé de gravure physico-chimique particulièrement abrasif. Il en résulte donc, pour fournir la localisation de cette gravure, qu'il est nécessaire de faire appel à un masque adapté, tel qu'un masque dur en dioxyde de silicium, ou un masque en résine, présentant une épaisseur relativement importante, ce masque étant lui-même gravé pendant la gravure de la couche active.

Ainsi, si un tel procédé de fabrication permet une parfaite individualisation des structures, il présente néanmoins l'inconvénient d'être relativement complexe à mettre en œuvre, puisqu'il nécessite l'utilisation d'un masque d'une épaisseur relativement importante. De plus, avec un tel procédé de fabrication des structures, les étapes d'individualisation des structures sont décorrélées du positionnement des inserts, il existe donc un risque important de problème d'alignement entre la délimitation de la structure et les inserts. Pour limiter ce dernier risque, il est donc nécessaire de surdimensionner la structure semiconductrice.

WO 2018/033689 A1 et US 2013/328013 A1 divulguent des procédés de fabrication de structures semiconductrices.

### Exposé de l'invention

L'invention vise à remédier ces inconvénients et a ainsi pour but de fournir un procédé de fabrication d'une structure semiconductrice destinée à être connectée par hybridation à un substrat support comprenant au moins une couche active dans un semiconduteur nitruré, ledit procédé étant simplifié vis-à-vis des procédés de l'art antérieur permettant la formation d'une telle structure semiconductrice, et fournissant un alignement entre les délimitations de la structure et les inserts.

L'invention concerne à cet effet, un procédé de fabrication d'une structure semiconductrice destinée à être connectée par hybridation à un substrat support, ladite structure comprenant les étapes suivantes :
- fourniture d'un premier support qui comporte un substrat et au moins une couche active, ladite couche active comprenant au moins un matériau semiconducteur nitruré, au moins une région active de ladite structure semiconductrice et au moins une première et une deuxième zone de connexion de ladite région active qui affleurent une surface du premier support étant aménagées dans la couche active,
- formation d'au moins un premier et un deuxième corps d'insert en contact électrique avec respectivement la première et la deuxième zone de connexion, ladite étape de formation comprenant la formation d'une couche de nickel recouvrant une portion de la surface du premier support, ladite couche de nickel étant disposée sur la surface du support au niveau de la région active en recouvrant au moins partiellement les première et deuxième zones de connexion,
- gravure physico-chimique localisée de la couche active, la localisation de la gravure étant fournie par une protection d'une partie de la couche active comprenant la région active par la couche de nickel,
- gravure physico-chimique de la couche de nickel, la gravure étant stoppée après libération d'au moins une partie de la surface du premier support de ladite couche de nickel, la partie de la surface du premier support comprenant la surface du premier support en dehors des première et deuxième zones de connexion, une portion restante de la couche de nickel et de chacun des premier et deuxième corps d'insert permettant la formation d'un premier et d'un deuxième insert,
- libération de la couche active du premier substrat, ladite libération permettant de former la structure semiconductrice.

De cette manière, la gravure localisée permettant d'individualiser la structure permet de fournir une délimitation de la structure qui est alignée avec les inserts. C'est en effet, la couche de nickel, qui est incluse dans les inserts, qui sert de masque lors de cette gravure localisée.

Qui plus est, le nickel présentant une vitesse de gravure relativement faible, voire sensiblement nulle, vis-à-vis des procédés de gravure physico-chimique utilisés pour graver les matériaux semiconducteur nitruré, il n'est pas nécessaire que cette couche présente une épaisseur importante comme c'est le cas pour le masque de gravure utilisé pour la gravure de la couche active dans l'art antérieur. Cette même couche de nickel participant à la formation de l'insert, le retrait des portions inutiles de ladite couche réalisée par gravure physico-chimique permet la formation des premier et deuxième inserts. Ainsi, contrairement à l'art antérieur, l'étape de retrait du masque utilisé pendant la gravure localisée de la couche active est pleinement utile, puisqu'elle participe à la formation des inserts. Il en résulte donc que le procédé de fabrication selon l'invention présente une simplification vis-à-vis des procédés de l'art antérieur.

Les termes « conducteur » et « isolant », lorsqu'ils sont utilisés ci-dessus et dans le reste de ce document, doivent s'entendre en tant que « conducteur électrique » et « isolant électrique ».

L'étape de formation du premier et deuxième insert peut comprendre les sous-étapes suivantes :
- formation d'au moins une première et une deuxième portion respective de couche métallique recouvrant respectivement la première et la deuxième zone de connexion,
- formation d'un premier et d'un deuxième corps d'insert en contact respectivement de la première et deuxième portions de couche métallique,
- dépôt de la couche de nickel en contact de la surface du support des première et deuxième portions de couche métallique et des premier et deuxième corps d'insert, la couche de nickel formant un revêtement des premier et deuxième corps d'insert.

De cette manière, la couche de nickel forme à la fois un revêtement des corps d'insert, en participant à la formation desdits inserts, et un masque de gravure pour la libération de la couche active permettant la singularisation de ladite structure semiconductrice. Une telle singularisation est particulièrement avantageuse dans le cadre d'une fabrication en parallèle de structure selon l'invention.

L'étape de formation du premier et deuxième corps d'insert peut comprendre les sous-étapes suivantes :
- formation d'au moins une première et une deuxième portion respective de couche métallique recouvrant respectivement la première et la deuxième zone de connexion,
- dépôt de la couche de nickel en recouvrant la surface du support libre de première et de deuxième portion de couche métallique et lesdites première et deuxième portions de couche métallique,
- formation d'un premier et d'un deuxième corps d'insert en contact avec la couche de nickel au niveau de, respectivement, la première et la deuxième portion de couche métallique.

De cette manière, la couche de nickel participe à la formation de la base de chacun des inserts.

Le premier et le deuxième corps d'insert peuvent comprendre du nickel.

De cette manière, et d'une manière similaire à la couche de nickel, les premier et deuxième corps d'insert ne sont pas ou peu gravés pendant l'étape de gravure physico-chimique localisée de la couche active.

Le premier et le deuxième corps d'insert peuvent comprendre un carbure parmi le carbure de silicium et le carbure de tungstène.

De tels matériaux sont particulièrement adaptés, en raison de leur dureté, à une connexion par hybridation de la structure semiconductrice à un deuxième support.

La couche active peut comprendre un nitrure de gallium.

Le procédé selon l'invention est particulièrement adapté pour un tel matériau de la couche active.

La partie active de la structure semiconductrice peut être une diode, les première et deuxième zones de connexion correspondant respectivement aux contacts métalliques de l'anode et de la cathode de ladite diode.

La couche active peut comprendre :
- une première sous-couche active présentant un premier type de conductivité, la deuxième zone de connexion étant une zone de connexion de ladite première sous-couche active,
- une zone active adaptée pour émettre de la lumière, ladite zone active comprenant préférentiellement au moins un puits quantique,
- une deuxième sous-couche active présentant un deuxième type de conductivité opposé au premier type de conductivité, la première zone de connexion étant une zone de connexion de ladite deuxième sous-couche active.

L'invention concerne en outre un procédé de fabrication d'un dispositif comprenant une structure semiconductrice, le procédé comprenant les étapes suivantes :
- formation d'une structure semiconductrice au moyen d'un procédé de fabrication selon l'invention,
- fourniture d'un deuxième support comprenant au moins une troisième et une quatrième zone de connexion en correspondance avec la première et la deuxième zone de connexion de la structure semiconductrice, et un premier et un deuxième plot en matériau conducteur ductile en contact électrique avec respectivement la troisième et la quatrième zone de connexion,
- connexion des première et deuxième zones de connexion avec respectivement les troisième et quatrième zones de connexion par insertion des premier et deuxième inserts dans respectivement le premier et le deuxième plot en matériau conducteur ductile.

Un tel procédé de fabrication bénéficie des bénéfices liés à une étape de fourniture d'une structure semiconductrice conforme au procédé de fabrication de l'invention.

La structure semiconductrice est une diode électroluminescente, le deuxième support comprenant un circuit de commande adapté pour alimenter et commander ladite diode électroluminescente.

### Brève description des dessins

La présente invention sera mieux comprise à la lecture de la description d'exemples de réalisation, donnés à titre purement indicatif et nullement limitatif, en faisant référence aux dessins annexés sur lesquels :
- la figure 1 est une vue en section d'un dispositif selon un premier mode de réalisation de l'invention, le dispositif comprenant une structure assemblée par hybridation sur un support de commande,
- la figure 2 est une vue en section d'une première étape d'un procédé de fabrication de la structure de la figure 1,
- la figure 3 est une vue en section d'une deuxième étape d'un procédé de fabrication de la structure de la figure 1,
- la figure 4 est une vue en section d'une troisième étape d'un procédé de fabrication de la structure de la figure 1,
- la figure 5 est une vue en section d'une quatrième étape d'un procédé de fabrication de la structure de la figure 1,
- la figure 6 est une vue en section d'une cinquième étape d'un procédé de fabrication de la structure de la figure 1,
- la figure 7 est une vue en section d'une sixième étape d'un procédé de fabrication de la structure de la figure 1,
- la figure 8 est une vue en section d'une septième étape d'un procédé de fabrication de la structure de la figure 1,
- la figure 9 est une vue en section d'une huitième étape d'un procédé de fabrication de la structure de la figure 1,
- la figure 10 est une vue en section d'une première étape d'un procédé de fabrication d'une structure selon un deuxième mode de réalisation de l'invention,
- la figure 11 est une vue en section d'une deuxième étape d'un procédé de fabrication d'une structure selon un deuxième mode de réalisation de l'invention,
- la figure 12 est une vue en section d'une troisième étape d'un procédé de fabrication d'une structure selon un deuxième mode de réalisation de l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### Exposé détaillé de modes de réalisation particuliers

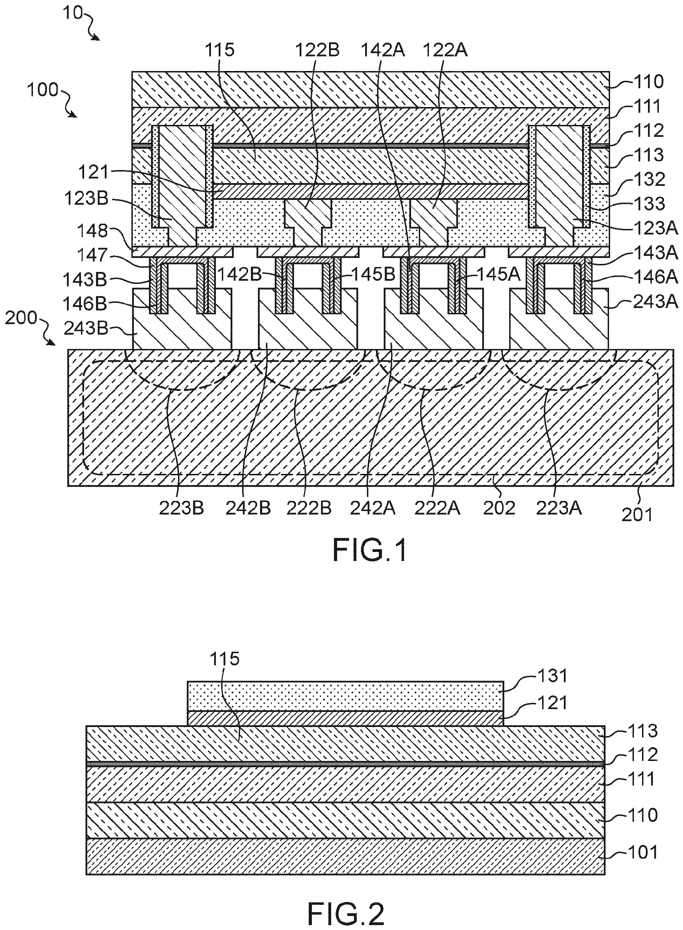

La figure 1 illustre, par une vue en section latérale, un dispositif semiconducteur 10, tel qu'un dispositif optoélectronique susceptible d'être obtenu au moyen d'un procédé de fabrication selon l'invention, ledit dispositif comprenant une structure semiconductrice 100, telle qu'une structure optoélectronique, assemblée par hybridation à un support 200, tel qu'un support de commande, dit deuxième support 200.

Dans une application usuelle de l'invention, la structure semiconductrice 100 est une structure optoélectronique. Plus précisément, dans le cadre du premier et du deuxième mode de réalisation décrits ci-après, correspondant un exemple d'application de l'invention, la structure semiconductrice 100 est une diode électroluminescente. Bien entendu, cet exemple d'application n'est nullement limitatif, l'invention couvre tout type de structure semiconductrice tel que par exemple les structures semiconductrices adaptées pour détecter un rayonnement électromagnétique, notamment les photodiodes.

Un tel dispositif semiconducteur comprend ainsi la structure semiconductrice 100 et le deuxième support 200 assemblé à ladite structure semiconductrice 100.

La structure semiconductrice comprend, comme illustré sur la figure 1 :
- une couche d'adaptation 110, présentant une première et une deuxième face,
- une première sous-couche active 111 présentant une première et une deuxième face, la première sous-couche active recouvrant la deuxième face de la couche d'adaptation 110 en ayant sa première face en contact de la deuxième face de la couche d'adaptation 110,
- une zone active 112 comprenant au moins un puits quantique, la zone active 112 recouvrant la deuxième face de la première sous-couche active 111 en ayant sa première face en contact de la deuxième face de la première sous-couche active 111,
- une deuxième couche active 113 présentant une première et une deuxième face, la deuxième sous-active 113 recouvrant la deuxième face de la zone active 112 en ayant sa première face en contact de la deuxième face de la zone active 112,
- une première couche métallique 121 recouvrant une première portion de la deuxième sous-couche active 113, la première couche métallique 121 présentant une première et une deuxième face et recouvrant ladite première portion de la deuxième sous-couche active 113 en étant en contact avec la deuxième face de la deuxième sous-couche active 113,
- une couche isolante 131, 132 recouvrant la première couche métallique 121 et la partie de la deuxième sous-couche active 113 qui est libre de première couche métallique 121, la couche isolante 131, 132 présentant une première et une deuxième face et la couche isolante 131, 132 recouvrant la deuxième face de la première couche métallique 121 et la deuxième face de la deuxième sous-couche active 113 qui est libre de première couche métallique 121 en étant en contact avec lesdites deuxièmes faces par sa première face, la deuxième face de la couche isolante 131, 132 formant une surface de la structure semiconductrice 100,
- un premier et un deuxième via métallique 122A, 122B s'étendant à partir de la première couche métallique 121 au travers de la couche isolante 131, 132 en débouchant à la surface de la couche isolante 131, 132 pour former une première et une deuxième première zone de connexion,
- un troisième et un quatrième via métallique 123A, 123B, s'étendant à partir de la première couche active 111 au travers de la zone active 112, la deuxième couche active 113 et la couche isolante 132 en débouchant à la surface de ladite couche isolante 132 pour former une première et une deuxième deuxième zone de connexion de ladite structure semiconductrice 100, le troisième et le quatrième via métallique 123A, 123B présentant chacun un revêtement isolant 133 agencé pour les isoler électriquement d'au moins la deuxième sous-couche active 113,
- un premier et un deuxième premier insert 142A, 142B en contact avec respectivement la première et la deuxième première zone de connexion 122A, 122B,
- un premier et un deuxième deuxième insert 143A, 143B en contact avec respectivement la première et le deuxième deuxième zone de connexion 123A, 123B.

Dans une telle structure, la première sous-couche active, la zone active et la troisième sous-couche active forment ensemble une couche active 111, 112, 113 de ladite structure semiconductrice 100 comprenant au moins un semiconducteur nitruré.

Un tel semiconducteur nitruré est un semiconducteur III-V comprenant de l'azote en tant qu'élément. Ainsi un tel semiconducteur nitruré peut être un alliage binaire, tel qu'un nitrure d'aluminium AIN, un nitrure de gallium GaN ou un nitrure d'indium InN, ou un alliage ternaire, tel qu'un arséniure-nitrure de Gallium GaAsN, un nitrure de gallium-alluminium AIGaN ou un nitrure de gallium-indium InGaN ou encore un alliage quaternaire, tel que arséniure-nitrure de gallium-aluminium AIGaAsN ou un arséniure-nitrure de gallium-indium InGaAsN. Dans une application préférentielle de l'invention, le semiconducteur nitruré est un nitrure de gallium GaN, les première et deuxième sous-couches actives 111, 113 étant constituées d'un tel semiconducteur et la zone active 113 étant alors choisie en fonction de la plage de longueurs d'onde d'émission choisie pour la structure semiconductrice 100.

Qui plus est, en raison du mode de fourniture de la couche active 111, 112, 113 selon ce premier mode de réalisation de l'invention, la composition de la couche d'adaptation 110 est choisie de manière à permettre une adaptation de réseau cristallin entre la couche active 111, 112, 113, c'est-à-dire la première sous-couche active 111 et le premier substrat 101, illustré notamment sur la figure 2, sur laquelle elle est formée. On notera que, selon l'application préférentielle de l'invention dans laquelle la première sous-couche active est réalisée dans un nitrure de gallium GaN, ledit premier substrat étant un substrat silicium Si, la couche d'adaptation 110 peut être une couche tampon de nitrure de gallium GaN avec une épaisseur comprise entre 1 nm et 500 nm, voire entre 5 nm et 100 nm.

Afin de former une diode électro-luminescente, la première sous-couche active 111 présente un premier type de conductivité, la deuxième sous-couche active 113 présentant un deuxième type de conductivité opposé au premier type de conductivité. Ainsi, par exemple la première sous-couche active 111 peut être dopée N, la deuxième sous-couche active étant alors dopée P. Dans l'application préférentielle de l'invention, à savoir une première et une deuxième couche en nitrure de gallium GaN. A titre d'exemple dans le cadre d'une telle application préférentielle, l'épaisseur de la première sous-couche active 111 est comprise entre 100 nm et 3 µm, par exemple de l'ordre de 700 nm. Selon ce même exemple, l'épaisseur de la deuxième sous-couche active 113 est comprise entre 50 nm et 300 nm, par exemple de l'ordre de 100 nm.

La zone active 112 est une zone sensiblement vide de porteurs et comportant au moins un puits quantique, et préférentiellement une pluralité de puits quantiques. La zone active est par exemple constituée par un empilement d'une ou plusieurs couches émissives formant chacune un puit quantique, par exemple à base d'au moins l'un parmi l nitrure de gallium GaN, le nitrure d'indium InN, les nitrure des gallium-indium InGaN, les nitrures de gallium-aluminium AIGaN, le nitrure d'aluminium AIN, les nitrures de gallium-indium-aluminium AlInGaN, le phosphore de gallium GaP, les phosphores de gallium-aluminium AIGaP, les phosphores de de gallium-indium aluminium AlInGaP, ou d'une combinaison d'un ou plusieurs de ces matériaux. A titre de variante, la zone active peut être une couche de nitrure de gallium GaN intrinsèque, c'est-à-dire non intentionnellement dopée, par exemple de concentration en donneurs résiduels comprise entre 10¹⁵ et 10¹⁸ atomes/cm³, par exemple de l'ordre de 10¹⁷ atomes/cm³. De tels puits quantiques peuvent être par exemple fournis par un empilement de couches nitrure de gallium-indium In_{X}Ga_{1-X}N/ nitrure de gallium GaN, X étant sélectionné dans une plage allant de 0 à 1, 0 et 1 exclut et étant choisie en fonction de la plage de longueurs d'onde choisie, conformément aux connaissances générales de l'homme du métier. De la même façon, les épaisseurs desdites couches de l'empilement sont adaptées, conformément aux connaissances générales de l'homme du métier, en fonction de la plage de longueurs d'onde choisie.

On notera que, à titre d'exemple, l'épaisseur de la zone active 112 peut être comprise entre 10 nm et 200 nm, par exemple de l'ordre de 100 nm.

On notera que selon l'application préférentielle, en variante, la zone active peut également comprendre des boîtes quantiques dont les dimensions et la composition sont adaptées en fonction de la plage de longueurs d'onde choisie.

On notera que, quoi qu'il en soit, et selon le principe de l'invention, au moins l'une de la première et la deuxième sous-couche active 111, 113 et de la zone active 112 comprend au moins un semiconduteur nitruré, tel que le nitrure de gallium GaN ou l'un parmi le nitrure de gallium GaN, le nitrure d'indium InN, les nitrure des gallium-indium InGaN, les nitrures de gallium-aluminium AIGaN, le nitrure d'aluminium AIN, les nitrures de gallium-indium-aluminium AlInGaN.

La première couche métallique 121 est adaptée pour former un contact ohmique avec la deuxième sous-couche active 113. Ainsi, selon l'application préférentielle de l'invention et dans le cas où la deuxième sous-couche présente un dopage P, la première couche métallique peut être formée, par exemple par un empilement comprenant une première sous-couche d'indium In et une deuxième sous-couche d'argent Ag ou encore par un empilement comprenant une première sous-couche d'oxyde d'indium-étain, connu sous le sigle ITO et correspondant à un mélange d'oxyde d'indium In₂O₃ et d'oxyde d'étain SnO₂, et une deuxième sous-couche d'argent Ag. La première couche métallique peut par exemple présenter une épaisseur comprise entre 1 nm et 5 µm, voire entre 5 nm et 1 µm ou encore entre 50 nm et 500 nm
La première couche métallique est agencée pour laisser libre une partie de la surface de la deuxième sous-couche 113 ceci de manière à autoriser un passage pour le troisième et le quatrième via 123A, 123B sans risque de court-circuit.

La couche isolante 132, quant à elle, peut être réalisée en dioxyde de silicium SiO2 ou en nitrure de silicium Si₂N₃.

La couche d'adaptation 110, la première sous-couche active 111, la zone active 112, la deuxième sous-couche active 113, la couche métallique 121, la couche isolante 132 forment ensemble un premier support 101, 110, 111, 112, 113, 121, 131.

Le troisième et le quatrième via métallique 123A, 123B s'étendent au travers de la couche active 112, de la deuxième sous-couche active 113 et de la couche isolante 132. Le troisième et quatrième via métallique 123A, 123B sont réalisés dans un matériau conducteur adapté pour former avec le matériau de la première sous-couche active 111 un contact ohmique. Ainsi, selon l'application préférentielle de l'invention, dans le cas où la première sous-couche active 111 est dopée N, le troisième et le quatrième via métallique 123A, 123B peuvent comprendre une couche d'accroche en contact avec la couche isolante titane Ti/nitrure de titane TiN et un cœur en cuivre Cu.

Chacun du troisième et du quatrième via métallique 123A, 123B est isolé de la zone active 112 et de la deuxième sous-couche active 113 par le revêtement isolant 133 qui s'interpose entre ledit via et lesdites zones actives 112 et deuxième sous-couche active 113. Le revêtement isolant 133 peut être de l'alumine Al₂O₃.

Le premier et le deuxième via métallique 122A, 122B s'étendent au travers de la couche isolante 131, 132 en contact avec la première couche métallique 121. Selon ce premier mode de réalisation, le premier et le deuxième via métallique 122A, 122B sont réalisés dans le même matériau métallique que celui du troisième et du quatrième via métallique 123A, 123B. Ainsi, selon l'application préférentielle de l'invention, le premier et le deuxième premier via 122A, 122B peuvent comprendre une couche d'accroche en contact avec le revêtement isolant 133 titane Ti/nitrure de titane TiN et un cœur en cuivre Cu

Le premier et le deuxième via métallique 122A, 122B et le troisième et le quatrième via métallique 123A, 123B affleurent la surface de la couche isolante 131 et donc de la structure semiconductrice 100. Le premier et le deuxième via métallique 122A, 122B forment ainsi la première zone de connexion et le troisième et le quatrième via métallique 123A, 123B forment la deuxième zone de connexion.

Les première et deuxième zones de connexion sont en contact avec respectivement le premier et le deuxième premier insert 142A, 142B et le premier et le deuxième deuxième insert 143A, 143B. Chacun des premier et deuxième premiers inserts 142A, 142B et des premier et deuxième deuxièmes inserts 143A, 143B, comprend :
- une portion de deuxième couche métallique 148 recouvrant la zone de connexion correspondant,
- un corps d'insert 145A, 145B, 146A, 146B,
- une couche de nickel 147 recouvrant partiellement le corps d'insert 145A, 145B, 146A, 146B.

Les portions de deuxième couche métallique 148 s'étendent chacune au-delà de la zone de connexion en recouvrant une partie de la surface de la couche isolante 131 et en étant à distance des unes des autres. Dans le cadre de l'application préférée de l'invention, la deuxième couche métallique 148 peut être une couche de nitrure de titane TiN.

Le corps d'insert 145A, 145B, 146A, 146B de chacun du premier et deuxième premier insert 142A, 142B et de chacun du premier et du deuxième deuxième insert 143A, 143B, présente une forme cylindrique de révolution creuse, la base opposée à la portion de deuxième couche métallique 148 correspondante étant absente.

Bien entendu, une telle forme cylindrique creuse du corps d'insert 145A, 145B, 146A, 146B n'est fournie qu'à titre d'exemple, le corps d'insert 145A, 145B, 146A, 146B de chacun du premier et deuxième premier insert 142A, 142B et de chacun du premier et du deuxième deuxième insert 143A, 143B peut être d'une autre forme, telle celle d'une tige ou d'une paroi, sans que l'on sorte du cadre de l'invention.

Selon l'application préférentielle de l'invention, le corps d'insert 145A, 145B, 146A, 146B de chacun du premier et deuxième premier insert 142A, 142B et de chacun du premier et du deuxième deuxième insert 143A, 143B, peut comprendre un empilement de couches comprenant une première couche titane Ti, une deuxième couche de nitrure de titane TiN et une troisième couche de carbure de silicium WSi, lesdites couches se succédant de l'extérieur de ladite forme cylindrique vers l'intérieur de cette même forme.

En variante, le corps d'insert 145A, 145B, 146A, 146B de chacun du premier et deuxième premier insert 142A, 142B et de chacun du premier et du deuxième deuxième insert 143A, 143B, peut comprendre un unique matériau sélectionné dans le groupe comportant le cuivre Cu, le Titane Ti, le tungstène W, le Chrome Cr, le nickel Ni, le platine Pt, le palladium Pd et leurs alliages, tels que le siliciure de tungstène WSi, le nitrure de tungstène WN et le nitrure de nickel TiN.

Le corps d'insert est recouvert par la couche de nickel 147 sur ces parois latérales, c'est-à-dire les parois sensiblement perpendiculaires à la surface de la première couche isolante 131, 132.

Le deuxième support 200 quant à lui comporte, comme illustré sur la figure 1 :
- un deuxième substrat 201 dans lequel est aménagé un circuit de commande 202 de la structure semiconductrice 100, le dit circuit de commande 202 présentant, d'une manière similaire à la structure semiconductrice 100, une première et une deuxième troisième zone de connexion 222A, 222B, en correspondance au première et deuxième première zone de connexion 122A, 122B de la structure semiconductrice 100, et une première et une deuxième quatrième zone de connexion 223A, 223B en correspondance avec la première et la deuxième deuxième zone de connexion 123A, 123B de la structure semiconductrice 100, lesdites première et deuxième troisièmes zones de connexion 222A, 222B et première et deuxième quatrièmes zones de connexion 223A, 223B affleurant la surface du deuxième support 200,
- un premier et un deuxième premier plot en matériau conducteur ductile 242A, 242B en contact avec respectivement la première et la deuxième troisième zone de connexion 222A, 222B,
- un premier et un deuxième deuxième plot en matériau conducteur ductile 243A, 243B en contact avec respectivement la première et la deuxième quatrième zone de connexion 223A, 223B.

Dans une configuration usuelle de l'invention, le deuxième support 201 est réalisé dans un matériau semiconducteur autre que celui de la couche active 111, 112, 113. Le deuxième support 201 est ainsi préférentiellement adapté pour la formation d'un circuit de commande et peut ainsi être réalisé dans un matériau semiconducteur parmi le silicium Si, le germanium Ge et les carbure de silicium SiC. Dans l'application préférentielle, le deuxième support 201 est réalisé en silicium Si.

Le circuit de commande 202 est un circuit de commande classique, tel qu'un circuit de technologie CMOS. De tels circuits de commande 202 étant connu de l'homme du métier, il n'est pas décrit plus précisément dans le présent document.

Le circuit de commande 202 présente la première et la deuxième troisième zone de connexion 222A, 222B et la première et la deuxième quatrième zone de connexion 223A, 223B.

Les premier et deuxième premier plots en matériau conducteur ductile 242A, 242B, et les premier et deuxième deuxième plots en matériau conducteur ductile 243A, 243B peuvent comprendre l'un parmi l'indium In, l'étain Sn, l'aluminium Al et l'un de ses alliages tels que les alliages plomb-étain SnPb et les alliages cuivre-argent-étain SnAgCu ou aluminium-cuivre AlCu.

Comme montré sur la figure 1, la structure semiconductrice 100 est assemblée par hybridation au deuxième support 200 ceci avec les premiers inserts 142A, 142B enchâssés dans les premiers plots en matériau conducteur ductile 242A, 242B correspondant et les deuxième inserts 143A, 143B enchâssés dans les deuxièmes plots en matériau conducteur ductile 243A, 243B.

Bien entendu, cette structure semiconductrice 100 et ce deuxième support 100 sont décrits en lien avec la figure 1 qui représente une vue en section latérale de ladite structure semiconductrice 100 et dudit deuxième support 200. Ainsi s'il n'est représenté sur cette figure, et donc décrit ci-dessus, uniquement qu'une première et deuxième première zone de connexion, qu'une première et deuxième deuxième zone de connexion, qu'un premier et deuxième premier insert 142A, 142B, qu'un premier et deuxième deuxième insert 143A, 143B, une structure semiconductrice 100 et un deuxième support 200 selon l'invention en comportent généralement plus. En effet, en conformité avec ce premier mode de réalisation, la structure semiconductrice 100 comporte, sur une partie centrale, quatre premières zones de connexion et autant de premiers inserts 142A, 142B et, sur une partie périphérique, douze deuxièmes zones de connexion et autant de deuxièmes inserts 143A, 143B. Bien entendu, afin de permettre l'assemblage entre la structure semiconductrice 100 et le deuxième support 200, le deuxième support 200 présente une configuration similaire avec un nombre correspondant de troisièmes zones de connexion 222A, 222B et de quatrièmes zones de connexion 223A, 223B.

On notera que, cela est bien entendu que ce premier mode de réalisation n'est qu'un exemple de réalisation de l'invention, et que la structure semiconductrice 100 peut avoir un nombre quelconque desdites première et deuxième zone de connexion 122A, 122B, 123A, 123B, desdits premier et deuxième inserts 142A, 142B, 143A, 143B ceci sans que l'on sorte du cadre de l'invention.

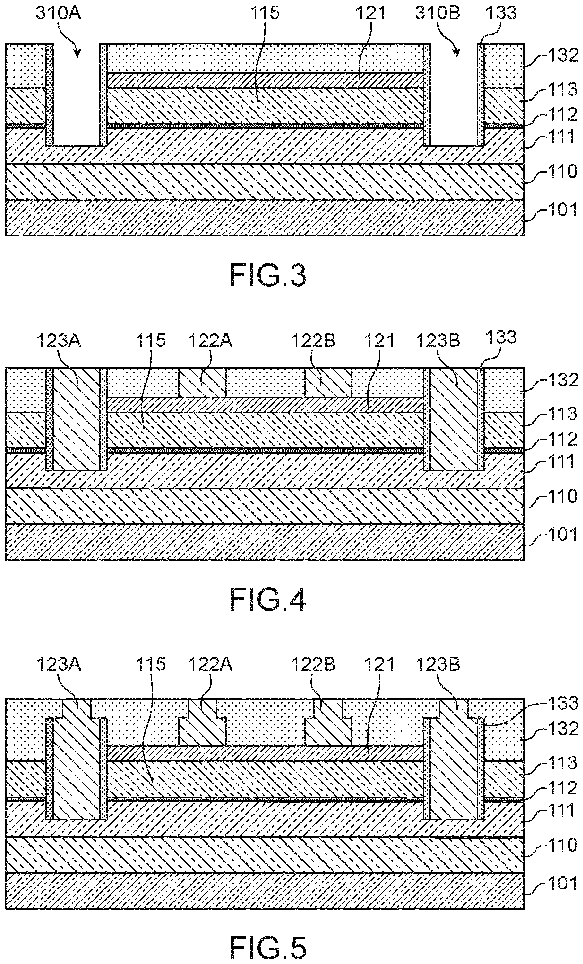

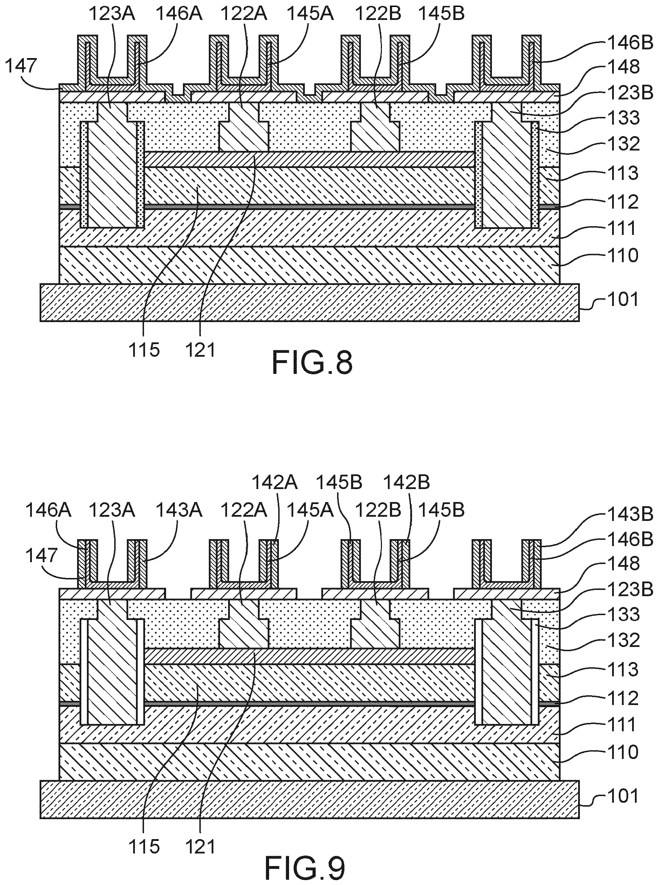

La structure semiconductrice 100 selon l'invention peut être formée au moyen d'un procédé de fabrication illustré sur les figures 2 à 9 et comprenant les étapes suivantes :
- fourniture d'un premier support 101, 110, 111, 112, 113, 121, 131 comportant le substrat 101 et une couche active 111, 112, 113, la couche active comprenant un semiconducteur nitruré, la région active 115 de la structure semiconductrice 100 et au moins une première et une deuxième zone de connexion de ladite région active 115 qui affleure une surface du premier support 101, 110, 111, 112, 113, 121, 131 étant aménagés dans ladite couche active 111, 112, 113, les étapes de ladite fourniture étant illustrée sur les figures 2 à 5,
- formation des premiers et des deuxièmes corps d'insert 145A, 145B, 146A, 146B en contact électrique avec respectivement la première et la deuxième zone de connexion, ladite étape de formation comprenant la formation de la couche de nickel 147 recouvrant une portion de la surface du premier support 101, 110, 111, 112, 113, 121, 131, ladite couche de nickel 147 étant disposée sur la surface support 101, 110, 111, 112, 113, 121, 131 au niveau de la région active 115 en recouvrant au moins partiellement les zones de connexion, les étapes de ladite formation étant illustrées sur les figure 5 à 7,
- gravure physico-chimique localisée de la couche active 111, 112, 113, une partie de la couche active 111, 112, 113 comprenant la région active 115 étant protégée par la couche de nickel 147, telle qu'illustrée sur la figure 8,
- gravure physico-chimique de la couche de nickel 147, la gravure étant stoppée après libération d'au moins une partie de la surface du premier support 101, 110, 111, 112, 113, 121, 131 de ladite couche de nickel 147, la partie de la surface du premier support 101, 110, 111, 112, 113, 121, 131 comprenant la surface du premier support 101, 110, 111, 112, 113, 121, 131 en dehors des première et deuxième zones de connexion, une portion restante de la couche de nickel 147 et de chacun des premier et deuxième corps d'insert 145A, 145B, 146A, 146B permettant la formation des premiers et des deuxièmes inserts 142A, 142B, 143A, 143B, telle qu'illustrée sur la figure 9,
- libération de la couche active 111, 112, 113 du premier substrat 101, ladite libération permettant de former la structure semiconductrice 100, conformément à la structure semiconductrice 100 illustrée sur la figure 1.

Ainsi, pendant l'étape de gravure localisée de la couche active 111, 112, 113 permettant de singulariser la structure semiconductrice 100, c'est la couche de nickel 147, participant à la formation des insert 142A, 142B, 143A, 143B, qui est utilisée en tant que masque de gravure. Cette gravure localisée permettant de singulariser la structure est donc aligné avec les éléments formant les inserts 142A, 142B, 143A, 143B et donc les inserts 142A, 142B, 143A, 143B eux-mêmes. Il est donc possible de réduire la taille de la structure semiconductrice au minimum et d'avoir un bon alignement entre la structure 100 et ses inserts 142A, 142B, 143A, 143B permettant de la connecter au deuxième support 200.

La première étape de fourniture du premier support 101, 110, 111, 112, 113, 121, 131 peut comprendre les sous-étapes suivantes :
- fourniture du premier substrat 101, ce premier substrat 101 pouvant être, dans le cadre de l'application préférentielle, un premier substrat 101 en silicium Si,
- dépôt de la couche d'adaptation 110 en contact du premier substrat, la couche d'adaptation 110 étant, dans le cadre de l'application préférentielle, une couche de nitrure de gallium GaN,
- dépôt de la première sous-couche 111 en contact de la couche d'adaptation 110, la première sous-couche 111 étant, dans le cadre de l'application préférentielle, une couche de nitrure de gallium GaN du premier type de conductivité,
- formation de la zone active 112, en contact de la première sous-couche 111, ladite zone active 112 comprenant, dans le cadre de l'application préférentielle, au moins un puits quantique,
- dépôt de la deuxième sous-couche active 113, en contact de la zone active 112, la deuxième sous-couche 113 étant, dans le cadre de l'application préférentielle, une couche de nitrure de gallium GaN du deuxième type de conductivité,
- dépôt de la première couche métallique 121, en contact de la deuxième sous couche active 113, la première couche métallique 121 étant, dans le cadre de l'application préférentielle, une couche de nitrure de titane TiN,
- dépôt d'une couche isolante sacrificielle 131 en contact de la première couche métallique 121, la première couche métallique 121 étant, dans le cadre de l'application préférentielle, une couche de dioxyde de silicium SiPO₂ ou de nitrure de silicium Si₂N₃,
- gravure localisée de la couche isolante sacrificielle 131 et de la première couche métallique 121 de manière à libérer une deuxième portion de la deuxième sous-couche active 113, comme illustré sur la figure 2,
- retrait de la couche isolante sacrificielle 131,
- dépôt d'une première partie de la couche isolante 132, ledit dépôt étant suivi d'une étape de planarisation de la couche isolante 132,
- formation d'une première et d'une deuxième percée 310A, 310B au travers de la couche isolante 132, la deuxième sous-couche active 113, la zone active 112, et d'une partie de la première sous-couche active 111, lesdites première et deuxième percées 310A, 310B débouchant dans la première couche active,
- dépôt du revêtement isolant 133 en contact du premier support 101, 110, 111, 112, 113, 121, 131, le revêtement isolant 133 étant notamment déposé en contact des parois latérales des première et deuxième percées 310A, 310B, ledit revêtement isolant 133 étant, dans le cadre de l'application préférentielle, de l'alumine Al₂O₃,
- gravure isotrope du revêtement isolant 133 de manière à libérer la surface du premier support 101, 110, 111, 112, 113, 121, 131 et le fond des première et deuxième percées 310A, 310B, comme illustré sur la figure 3,
- formation d'une troisième et d'une quatrième percée au travers de la couche isolante 132, lesdites troisième et quatrième percées 310A, 310B débouchant dans la première couche métallique 121,
- dépôt d'un matériau métallique de manière à remplir les première, deuxième, troisième et quatrième percées 310A, 310B, le dépôt étant suivi d'une étape de planarisation de manière à libérer la couche isolante 132 de matériau métallique, ledit matériau métallique étant, dans le cadre de l'application préférentielle, une première couche d'accroche titane Ti/nitrure de titane TiN et un cœur en cuivre Cu, comme illustré sur la figure 4,
- dépôt d'une deuxième partie de la couche isolante 132 en contact de la première partie de la couche isolante 132,
- formation d'une cinquième, sixième, septième et huitième percée dans le prolongement de respectivement les première, deuxième, troisième et quatrième percées 310A, 310B et débouchant dans ladite percée 310A, 310B, ces percées étant de dimensions inférieurs à celles des première, deuxième, troisième et quatrième percées 310A, 310B,
- dépôt d'un matériau métallique de manière à remplir les cinquième, sixième, septième et huitième percées 310A, 310B, le dépôt étant suivi d'une étape de planarisation de manière à libérer la couche isolante 132 de matériau métallique, ledit matériau métallique étant, dans le cadre de l'application préférentielle, une première couche d'accroche titane Ti/nitrure de titane TiN et un cœur en cuivre Cu, le premier support 101, 110, 111, 112, 113, 121, 131 étant ainsi formé, comme illustré sur la figure 5.

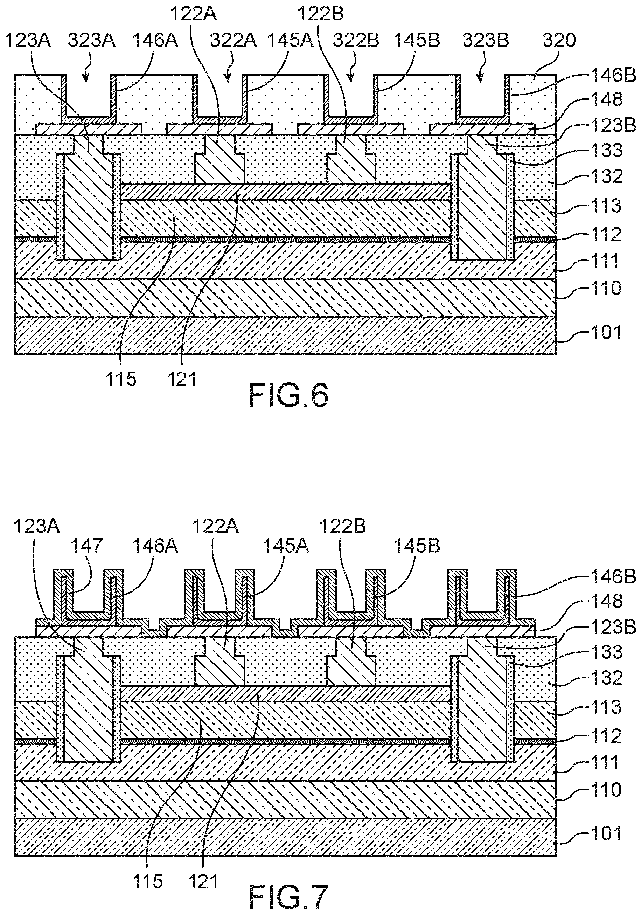

L'étape de formation des premiers et des deuxièmes corps d'insert 145A, 145B, 146A, 146B en contact électrique avec respectivement la première et la deuxième zone de connexion peut comprendre les sous-étapes :
- dépôt de la deuxième couche métallique 148 en contact avec la surface du premier support 101, 110, 111, 112, 113, 121, 131, ladite deuxième couche métallique 148 étant, dans le cadre de l'application préférentielle, une couche de nitrure de titane TiN,
- gravure localisé de la deuxième couche métallique 148 de manière à libérer une partie de la surface du premier support 101, 110, 111, 112, 113, 121, 131, et ainsi former une portion de couche métallique 148 en contact de chacune des première et deuxième première zone de connexion et des première et deuxième deuxième zone de connexion,
- formation d'un masque en résine photosensible 320 en contact de la deuxième couche de métallique 148 et de la partie de la surface du premier support 101, 110, 111, 112, 113, 121, 131 libre de couche métallique 148, ledit masque en résine étant muni d'une première et deuxième première percée 322A, 322B débouchant sur les portion de deuxième couche métallique 148 en contact avec les première et deuxième première zone de connexion et d'une première et deuxième deuxième percée 323A, 323B débouchant sur les portion de deuxième couche métallique 148 en contact avec les première et deuxième deuxième zone de connexion et étant, dans le cadre de l'application préférentielle une résine polymère telle qu'un polyamide,
- dépôt d'une couche du ou des matériaux destinés à former les corps d'insert 145A, 145B, 146A, 146B en contact de la surface du masque de résine, des parois des première et deuxième première percées 322A, 322A, des parois des première et deuxième deuxième percées 323A, 323B et des portions de deuxième couche métallique 148 libre de masque en résine photosensible 220, ce dépôt consistant, dans le cadre de l'application préférentielle, à un dépôt successif de titane Ti, de nitrure de titane TiN et de carbure de silicium WSi, le dépôt étant suivi d'une étape de planarisation de manière à libérer la surface du masque en résine de la couche du ou des matériaux destinés à former les corps d'insert 145A, 145B, 146A, 146B, les premier et deuxième premier corps d'insert 145A, 145B et les premier et deuxième deuxième corps d'insert 146A, 146B étant ainsi formés, comme illustré sur la figure 6,
- suppression du masque en résine photosensible 320,
- dépôt de nickel Ni de manière à former la couche de nickel 147 en contact avec les premier et deuxième premiers corps d'insert 145A, 145B, les premier et deuxième deuxièmes corps d'insert 146A, 146B, les portions de deuxième couche métallique 148 libre de corps d'insert 145A, 145B, 146A, 146B et les parties de la surface du premier support 101, 110, 111, 112, 113, 121, 131 libre de portions de deuxième couche métallique 148,
- gravure localisé de la couche de nickel 147 de manière à ce que la partie restante de la couche de nickel 147 recouvre une portion de la surface du premier support 101, 110, 111, 112, 113, 121, 131, ladite couche de nickel 147 étant disposée sur la surface support 101, 110, 111, 112, 113, 121, 131 au niveau de la région active 115 en recouvrant au moins partiellement les zones de connexion, ladite gravure étant une gravure physico chimique, tel qu'une gravure ionique, la localisation étant fournie par l'utilisation d'un masque adapté supprimé après gravure, comme illustré sur la figure 7.

Pendant l'étape de gravure physico-chimique localisée de la couche active 111, 112, 113 et dans le cadre de l'application préférentielle, la gravure physico-chimique peut être une gravure au plasma chloré, comme illustré sur la figure 8.

Pendant l'étape de gravure de la couche de nickel 147 et dans le cadre de l'application préférentielle, la gravure physico-chimique peut être une gravure ionique.

La structure semiconductrice 100 ainsi formée est adaptée pour être connectée au deuxième support 200 afin de former le dispositif semiconducteur 10 selon l'invention. Une telle connexion peut être réalisée au moyen d'un procédé d'assemblage par hybridation comprenant l'étape suivante :
- connexion des première et deuxième zones de connexion avec respectivement les troisième et quatrième zones de connexion 222A, 222B, 223A, 223B par insertion des premier et deuxième inserts 142A, 142B, 143A, 143B dans respectivement le premier et le deuxième plot en matériau conducteur ductile 242A, 242B, 243A, 243B.

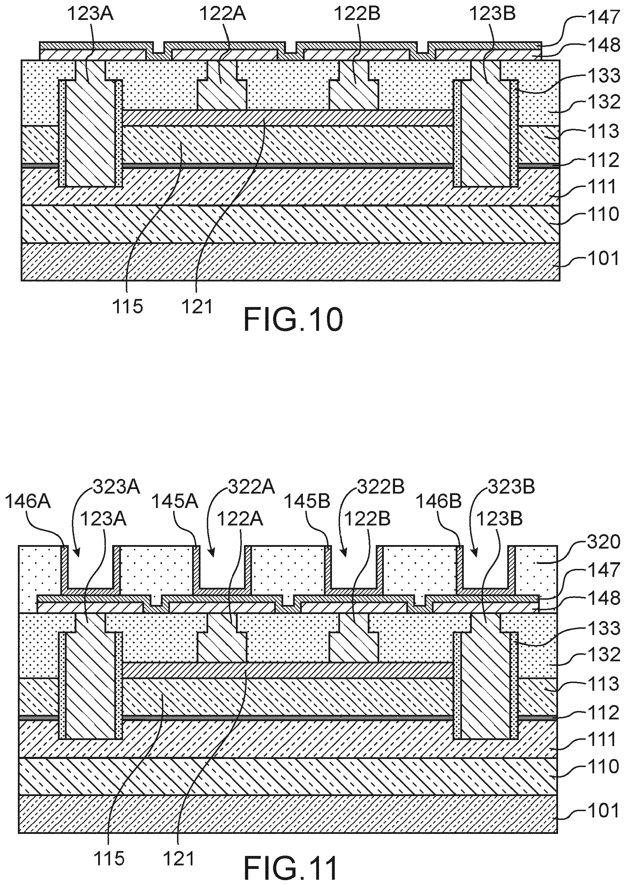

Les figures 10 à 12 illustrent des étapes d'un procédé de fabrication d'une structure semiconductrice selon un deuxième mode de réalisation. Un procédé de fabrication selon ce deuxième mode de réalisation se différencie d'un procédé selon le premier mode de réalisation en ce que l'étape de dépôt de la couche de nickel 147 est préalable à la formation d'un masque en résine photosensible 220.

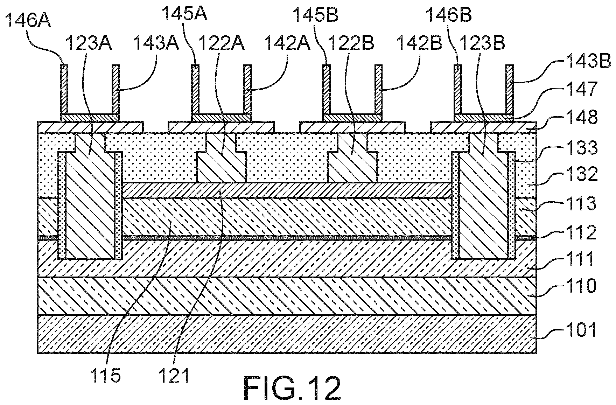

Ainsi avec un procédé de fabrication selon ce deuxième mode de réalisation, l'étape de formation d'au moins un premier et un deuxième corps d'insert 145A, 145B, 146A, 146B en contact électrique avec respectivement la première et la deuxième zone de connexion peut comprendre, après la sous-étape de gravure localisée de la deuxième couche métallique 148 de manière à libérer une partie de la surface du premier support 101, 110, 111, 112, 113, 121, 131, les sous-étapes suivantes :
- dépôt de nickel Ni de manière à former la couche de nickel 147 en contact avec les portions de deuxième couche métallique 148, et les parties de la surface du premier support 101, 110, 111, 112, 113, 121, 131 libres de portions de deuxième couche métallique 148,
- gravure localisée de la couche de nickel 147 de manière à ce que la partie restante de la couche de nickel 147 recouvre une portion de la surface du premier support 101, 110, 111, 112, 113, 121, 131, ladite couche de nickel 147 étant disposée sur la surface support 101, 110, 111, 112, 113, 121, 131 au niveau de la région active 115 en recouvrant au moins partiellement les zones de connexion, ladite gravure étant une gravure physico chimique, tel qu'une gravure ionique, la localisation étant fournie par l'utilisation d'un masque adapté supprimé après gravure, comme illustré sur la figure 10,
- formation d'un masque en résine photosensible 320 en contact de la couche de nickel 147 et de la partie de la surface du premier support 101, 110, 111, 112, 113, 121, 131 libre de couche de nickel 147, ledit masque en résine étant muni d'une première et deuxième première percée 322A, 322B débouchant sur la couche de nickel 147 au niveau des première et deuxième première zone de connexion et d'une première et deuxième percée 323A, 323B débouchant sur la couche de nickel 147 au niveau des première et deuxième deuxième zones de connexion et étant, dans le cadre de l'application préférentielle une résine polymère telle qu'un polyamide,
- dépôt d'une couche du ou des matériaux destinés à former les corps d'insert 145A, 145B, 146A, 146B en contact de la surface du masque de résine, des parois des première et deuxième première percées 322A, 322A, des parois des première et deuxième deuxième percées 323A, 323B et des portions de couche de nickel 147 libres de masque en résine photosensible 220, ce dépôt consistant, dans le cadre de l'application préférentielle, à un dépôt successif de titane Ti, de nitrure de titane TiN et du nickel Ni, le dépôt étant suivi d'une étape de planarisation de manière à libérer la surface de du masque de résine de la couche du ou des matériaux destinés à former les corps d'insert 145A, 145B, 146A, 146B, les premier et deuxième premier corps d'insert 145A, 145B et les premier et deuxième deuxième corps d'insert 145A, 145B étant ainsi formés, comme illustré sur la figure 11,
- suppression du masque en résine photosensible 320, comme illustré sur la figure 12.

On notera que, conformément à l'application préférée décrite ci-dessus, de manière à limiter la partie de chacun des corps d'insert 145A, 145B, 146A, 146B gravée pendant les étapes de gravure physico-chimique localisée de la couche active 111, 112, 113, et de gravure physico-chimique de la couche de nickel 147, chacun des corps d'insert 145A, 145B, 146A, 146B comprend préférentiellement du nickel Ni.

Ainsi, les corps d'insert 145A, 145B, 146A, 146B sont peu ou pas gravés pendant l'étape de gravure physico-chimique localisée de la couche active 111, 112, 113 et présentent une gravure anisotrope pendant l'étape de gravure physico-chimique de la couche de nickel 147. Cette gravure anisotrope entraine, comme montrée sur la figure 12, une gravure de la partie des corps d'insert 145A, 145B, 146A, 146B au niveau de la base et du sommet de la forme cylindrique, la partie de la couche de nickel 147, protégé par ladite base, formant alors la base de l'insert 142A, 142B, 143A, 143B formée après ladite gravure.

Conformément à cette possibilité, on notera qu'une structure semiconductrice 100 selon ce deuxième mode de réalisation se différencie d'une structure semiconductrice selon le premier en ce que pour chacun des premier et deuxième premier insert 142A, 142B, 143A, 143B :
- le corps d'insert 145A, 145B présente une forme de cylindre creux dépourvu de base,
- la couche de nickel 147 forme la base du corps d'insert 145A, 145B, 146A, 146B en contact avec la portion de deuxième couche métallique 148 correspondante, ladite couche de nickel ne revêtant pas les parois latérale du corps d'insert 145A, 145B, 146A, 146B.

## Revendications

1. Procédé de fabrication d'une structure semiconductrice (100) destinée à être connectée par hybridation à un deuxième support (200), le procédé de fabrication comprenant les étapes suivantes :
- fourniture d'un premier support (101, 110, 111, 112, 113, 121, 131) qui comporte un substrat (101) et au moins une couche active (111, 112, 113), ladite couche active (111, 112, 113) comprenant au moins un matériau semiconducteur nitruré, au moins une région active (115) de ladite structure semiconductrice (100) et au moins une première et une deuxième zone de connexion de ladite région active (115) qui affleurent une surface du premier support (101, 110, 111, 112, 113, 121, 131) étant aménagées dans la couche active (111, 112, 113),
- formation d'au moins un premier et un deuxième corps d'insert (145A, 145B, 146A, 146B) en contact électrique avec respectivement la première et la deuxième zone de connexion, ladite étape de formation comprenant la formation d'une couche de nickel (147) recouvrant une portion de la surface du premier support (101, 110, 111, 112, 113, 121, 131), ladite couche de nickel (147) étant disposée sur la surface du support (101, 110, 111, 112, 113, 121, 131) au niveau de la région active (115) en recouvrant au moins partiellement les première et deuxième zones de connexion,
- gravure physico-chimique localisée de la couche active (111, 112, 113), la localisation de la gravure étant fournie par une protection d'une partie de la couche active (111, 112, 113) comprenant la région active (115) par la couche de nickel (147),
- gravure physico-chimique de la couche de nickel (147), la gravure étant stoppée après libération d'au moins une partie de la surface du premier support (101, 110, 111, 112, 113, 121, 131) de ladite couche de nickel (147), la partie de la surface du premier support (101, 110, 111, 112, 113, 121, 131) comprenant la surface du premier support (101, 110, 111, 112, 113, 121, 131) en dehors des première et deuxième zones de connexion, une portion restante de la couche de nickel (147) et de chacun des premier et deuxième corps d'insert (145A, 145B, 146A, 146B) permettant la formation d'un premier et d'un deuxième insert (142A, 142B, 143A, 143B),
- libération de la couche active (111, 112, 113) du premier substrat (101), ladite libération permettant de former la structure semiconductrice (100).

2. Procédé de fabrication selon la revendication 1, dans lequel l'étape de formation du premier et deuxième insert (142A, 142B, 143A, 143B) comprend les sous-étapes suivantes :
- formation d'au moins une première et une deuxième portion respective de couche métallique (148) recouvrant respectivement la première et la deuxième zone de connexion,
- formation d'un premier et d'un deuxième corps d'insert (145A, 145B, 146A, 146B) en contact respectivement de la première et de la deuxième portion de couche métallique (148),
- dépôt de la couche de nickel (147) en contact de la surface du support (101, 110, 111, 112, 113, 121, 131) des première et deuxième portions de couche métallique (148) et des premier et deuxième corps d'insert (145A, 145B, 146A, 146B), la couche de nickel (147) formant un revêtement des premier et deuxième corps d'insert (145A, 145B, 146A, 146B).

3. Procédé de fabrication selon la revendication 1, dans lequel l'étape de formation du premier et deuxième corps d'insert (145A, 145B, 146A, 146B) comprend les sous-étapes suivantes :
- formation d'au moins une première et une deuxième portion respective de couche métallique (148) recouvrant respectivement la première et la deuxième zone de connexion,
- dépôt de la couche de nickel (147) en recouvrant la surface du support (101, 110, 111, 112, 113, 121, 131) libre de première et de deuxième portion de couche métallique (148) et lesdites première et deuxième portions de couche métallique (148),
- formation d'un premier et d'un deuxième corps d'insert (145A, 145B, 146A, 146B) en contact avec la couche de nickel (147) au niveau de, respectivement, la première et la deuxième portion de couche métallique (148).

4. Procédé de fabrication selon la revendication 3, dans lequel le premier et le deuxième corps d'insert (145A, 145B, 146A, 146B) comprend du nickel.

5. Procédé de fabrication selon l'une quelconque des revendications 1 à 4, dans lequel le premier et le deuxième corps d'insert (145A, 145B, 146A, 146B) comprend un carbure parmi le carbure de silicium et le carbure de tungstène.

6. Procédé de fabrication selon l'une quelconque des revendications 1 à 5 dans lequel la couche active (111, 112, 113) comprend un nitrure de gallium.

7. Procédé de fabrication selon l'une quelconque des revendications 1 à 6, dans lequel la partie active (115) de la structure semiconductrice (100) est une diode, les première et deuxième zones de connexion correspondant à respectivement aux contacts métalliques (122A, 122B, 123A, 123B) de l'anode et de la cathode de ladite diode.

8. Procédé de fabrication d'une structure semiconductrice (100) selon la revendication 7, dans laquelle la couche active comprend :
- une première sous-couche active (111) présentant un premier type de conductivité, la deuxième zone de connexion étant une zone de connexion de ladite première sous-couche active (111),
- une zone active (112) adaptée pour émettre de la lumière, ladite zone active (112) comprenant préférentiellement au moins un puits quantique,
- une deuxième sous-couche active (113) présentant un deuxième type de conductivité opposé au premier type de conductivité, la première zone de connexion étant une zone de connexion de ladite deuxième sous-couche active (113).

9. Procédé de fabrication d'un dispositif semiconducteur (10) comprenant une structure semiconductrice (100), le procédé comprenant les étapes suivantes :
- formation d'une structure semiconductrice (100) au moyen d'un procédé de fabrication selon l'une quelconque des revendications 1 à 8,
- fourniture d'un deuxième support (201) comprenant au moins une troisième et une quatrième zone de connexion (222A, 222B, 223A, 223B) en correspondance avec la première et la deuxième zone de connexion de la structure semiconductrice (100), et un premier et un deuxième plot en matériau conducteur ductile (242A, 242B, 243A, 243B) en contact électrique avec respectivement la troisième et la quatrième zone de connexion (222A, 222B, 223A, 223B),
- connexion des première et deuxième zones de connexion avec respectivement les troisième et quatrième zones de connexion (222A, 222B, 223A, 223B) par insertion des premier et deuxième inserts (142A, 142B, 143A, 143B) dans respectivement le premier et le deuxième plot en matériau conducteur ductile (242A, 242B, 243A, 243B).

10. Procédé de fabrication d'un dispositif selon la revendication 9, dans lequel la structure semiconductrice (100) est une diode électroluminescente, le deuxième support (201) comprenant un circuit de commande (202) adapté pour alimenter et commander ladite diode électroluminescente.

## Patentansprüche

1. Verfahren zum Herstellen einer Halbleiterstruktur (100), die durch Hybridisierung mit einem zweiten Träger (200) verbunden werden soll, wobei das Herstellungsverfahren die folgenden Schritte umfasst:
- Bereitstellen eines ersten Trägers (101, 110, 111, 112, 113, 121, 131), der ein Substrat (101) und zumindest eine aktive Schicht (111, 112, 113) enthält, wobei die aktive Schicht (111, 112, 113) zumindest ein nitriertes Halbleitermaterial enthält, wobei zumindest ein aktiver Bereich (115) der Halbleiterstruktur (100) und zumindest ein erster und ein zweiter Anschlussbereich des aktiven Bereichs (115), die mit einer Oberfläche des ersten Substrats (101, 110, 111, 112, 113, 121, 131) bündig liegen, in der aktiven Schicht (111, 112, 113) vorgesehen sind,
- Ausbilden zumindest eines ersten und eines zweiten Einsatzkörpers (145A, 145B, 146A, 146B) in elektrischem Kontakt mit dem ersten bzw. dem zweiten Anschlussbereich, wobei der Schritt des Ausbildens das Bilden einer Nickelschicht (147) umfasst, die einen Abschnitt der Oberfläche des ersten Trägers (101, 110, 111, 112, 113, 121, 131) bedeckt, wobei die Nickelschicht (147) auf der Oberfläche des Trägers (101, 110, 111, 112, 113, 121, 131) im Bereich des aktiven Bereichs (115) angeordnet ist und zumindest teilweise den ersten und den zweiten Anschlussbereich abdeckt,
- lokalisiertes physikalisch-chemisches Ätzen der aktiven Schicht (111, 112, 113), wobei die Lokalisierung des Ätzens durch einen Schutz eines Teils der aktiven Schicht (111, 112, 113), der den aktiven Bereich (115) enthält, durch die Nickelschicht (147) sichergestellt wird,
- physikalisch-chemisches Ätzen der Nickelschicht (147), wobei das Ätzen gestoppt wird, nachdem zumindest ein Teil der Oberfläche des ersten Trägers (101, 110, 111, 112, 113, 121, 131) von der Nickelschicht (147) freigelegt wurde, wobei der Teil der Oberfläche des ersten Trägers (101, 110, 111, 112, 113, 121, 131) die Oberfläche des ersten Trägers (101, 110, 111, 112, 113, 121, 131) außerhalb des ersten und des zweiten Anschlussbereichs enthält, wobei ein verbleibender Teil der Nickelschicht (147) und jedes aus erstem und zweitem Einsatzkörper (145A, 145B, 146A, 146B) die Bildung eines ersten und eines zweiten Einsatzes (142A, 142B, 143A, 143B) ermöglicht,
- Freilegen der aktiven Schicht (111, 112, 113) von dem ersten Substrat (101), wobei das Freilegen die Bildung der Halbleiterstruktur (100) ermöglicht.

2. Herstellungsverfahren nach Anspruch 1, wobei der Schritt des Bildens des ersten und des zweiten Einsatzes (142A, 142B, 143A, 143B) die folgenden Teilschritte umfasst:
- Ausbilden zumindest eines jeweiligen ersten und zweiten Metallschichtabschnitts (148), der den ersten bzw. zweiten Anschlussbereich abdeckt,
- Ausbilden eines ersten und eines zweiten Einsatzkörpers (145A, 145B, 146A, 146B) in Kontakt mit dem ersten bzw. zweiten Metallschichtabschnitt (148),
- Abscheiden der Nickelschicht (147) in Kontakt mit der Oberfläche des Trägers (101, 110, 111, 112, 113, 121, 131) des ersten und des zweiten Metallschichtabschnitts (148) und des ersten und des zweiten Einsatzkörpers (145A, 145B, 146A, 146B), wobei die Nickelschicht (147) eine Beschichtung des ersten und des zweiten Einsatzkörpers (145A, 145B, 146A, 146B) bildet.

3. Herstellungsverfahren nach Anspruch 1, wobei der Schritt des Bildens des ersten und des zweiten Einsatzkörpers (145A, 145B, 146A, 146B) die folgenden Teilschritte umfasst:
- Ausbilden zumindest eines jeweiligen ersten und zweiten Metallschichtabschnitts (148), der den ersten bzw. zweiten Anschlussbereich abdeckt,
- Abscheiden der Nickelschicht (147) unter Bedecken der von dem ersten und dem zweiten Metallschichtabschnitt (148) freigelegten Oberfläche des Trägers (101, 110, 111, 112, 113, 121, 131) und des ersten und des zweiten Metallschichtabschnitt (148),
- Ausbilden eines ersten und eines zweiten Einsatzkörpers (145A, 145B, 146A, 146B) in Kontakt mit der Nickelschicht (147) im Bereich des ersten bzw. zweiten Metallschichtabschnitts (148).

4. Herstellungsverfahren nach Anspruch 3, wobei der erste und der zweite Einsatzkörper (145A, 145B, 146A, 146B) Nickel enthalten.

5. Herstellungsverfahren nach einem der Ansprüche 1 bis 4, wobei der erste und der zweite Einsatzkörper (145A, 145B, 146A, 146B) ein Karbid aus Siliciumcarbid und Wolframkarbid enthalten.

6. Herstellungsverfahren nach einem der Ansprüche 1 bis 5, wobei die aktive Schicht (111, 112, 113) ein Galliumnitrid enthält.

7. Herstellungsverfahren nach einem der Ansprüche 1 bis 6, wobei der aktive Teil (115) der Halbleiterstruktur (100) eine Diode ist, wobei der erste und der zweite Anschlussbereich den Metallkontakten (122A, 122B, 123A, 123B) der Anode bzw. Kathode der Diode entsprechen.

8. Verfahren zum Herstellen einer Halbleiterstruktur (100) nach Anspruch 7, wobei die aktive Schicht enthält:
- eine erste aktive Teilschicht (111) mit einem ersten Leitfähigkeitstyp, wobei der zweite Anschlussbereich ein Anschlussbereich der ersten aktiven Teilschicht (111) ist,
- einen aktiven Bereich (112), der dazu geeignet ist, Licht zu emittieren, wobei der aktive Bereich (112) vorzugsweise zumindest einen Quantentopf umfasst,
- eine zweite aktive Teilschicht (113) mit einem zweiten Leitfähigkeitstyp, der dem ersten Leitfähigkeitstyp entgegengesetzt ist, wobei der erste Anschlussbereich ein Anschlussbereich der zweiten aktiven Teilschicht (113) ist.

9. Verfahren zum Herstellen einer Halbleitervorrichtung (10) mit einer Halbleiterstruktur (100), wobei das Verfahren die folgenden Schritte umfasst:
- Ausbilden einer Halbleiterstruktur (100) mittels eines Herstellungsverfahrens nach einem der Ansprüche 1 bis 8,
- Bereitstellen eines zweiten Trägers (201), der zumindest einen dritten und einen vierten Anschlussbereich (222A, 222B, 223A, 223B) in Übereinstimmung mit dem ersten und dem zweiten Anschlussbereich der Halbleiterstruktur (100) und ein erstes und ein zweites Pad aus duktilem, leitfähigem Material (242A, 242B, 243A, 243B) in elektrischem Kontakt mit dem dritten bzw. dem vierten Anschlussbereich (222A, 222B, 223A, 223B) enthält,
- Verbinden der ersten und des zweiten Anschlussbereichs mit dem dritten bzw. vierten Anschlussbereich (222A, 222B, 223A, 223B) durch Einsetzen des ersten und des zweiten Einsatzes (142A, 142B, 143A, 143B) in das erste bzw. zweite Pad aus duktilem leitfähigem Material (242A, 242B, 243A, 243B).

10. Verfahren zum Herstellen einer Vorrichtung nach Anspruch 9, wobei die Halbleiterstruktur (100) eine Leuchtdiode ist, wobei der zweite Träger (201) eine Steuerschaltung (202) enthält, die dazu geeignet ist, die Leuchtdiode zu versorgen und zu steuern.

## Claims

1. Method for fabrication of a semiconducting structure (100) intended to be connected by hybridisation to a second support (200), the method for fabrication including the following steps:
- supply a first support (101, 110, 111, 112, 113, 121, 131) that comprises a substrate (101) and at least one active layer (111, 112, 113), said active layer (111, 112, 113) comprising at least one nitrided semiconducting material, at least one active region (115) of said semiconducting structure (100) and at least one first and one second connection zone of said active region (115) flush with a surface of the first support (101, 110, 111, 112, 113, 121, 131) being arranged in said active layer (111, 112, 113),
- formation of at least one first and one second insert body (145A, 145B, 146A, 146B) in electrical contact with the first and second connection zones respectively, said formation step comprising formation of a nickel layer (147) covering a portion of the surface of the first support (101, 110, 111, 112, 113, 121, 131), said nickel layer (147) being arranged on the support surface (101, 110, 111, 112, 113, 121, 131) at the active region (115), at least partially covering the first and second connection zones,
- localised physico-chemical etching of the active layer (111, 112, 113), the localisation of the etching being provided by protecting part of the active layer (111, 112, 113) comprising the active region (115) by the nickel layer (147),
- physico-chemical etching of the nickel layer (147), the etching being stopped after the release of at least part of the surface of the first support (101, 110, 111, 112, 113, 121, 131) of said nickel layer (147), the part of the surface of the first support (101, 110, 111, 112, 113, 121, 131) including the surface of the first support (101, 110, 111, 112, 113, 121, 131) outside the first and second connection zones, a remaining portion of the nickel layer (147) and each of the first and second insert bodies (145A, 145B, 146A, 146B) being used for formation of a first and a second insert (142A, 142B, 143A, 143B),
- release of the active layer (111, 112, 113) from the first substrate (101), said release enabling formation of the semiconducting structure (100).

2. The method of fabrication according to claim 1, wherein the step for formation of the first and second inserts (142A, 142B, 143A, 143B) includes the following sub-steps:
- formation of at least a first and a second portion of the metallic layer (148) covering the first and second connection zones respectively,
- formation of a first and a second insert body (145A, 145B, 146A, 146B) in contact with the first and the second metallic layer portions (148), respectively,
- deposition of the nickel layer (147) in contact with the support surface (101, 110, 111, 112, 113, 121, 131) of the first and second portions of metallic layer (148) and the first and second insert bodies (145A, 145B, 146A, 146B), the nickel layer (147) forming a coating of the first and second insert bodies (145A, 145B, 146A, 146B).

3. The method of fabrication according to claim 1, wherein the step for formation of the first and second insert bodies (145A, 145B, 146A, 146B) includes the following sub-steps:
- formation of at least a first and a second portion of the metallic layer (148) covering the first and second connection zones respectively,
- deposition of the nickel layer (147) covering the support surface (101, 110, 111, 112, 113, 121, 131) that is free of the first and second metallic layer portions (148) and said first and second metallic layer portions (148),
- formation of a first and a second insert body (145A, 145B, 146A, 146B) in contact with the nickel layer (147) at the first and second metallic layer portions (148), respectively,

4. The method of fabrication according to claim 3, wherein the first and second insert bodies (145A, 145B, 146A, 146B) comprise nickel:

5. The method of fabrication according to any one of claims 1 to 4, wherein the first and second insert bodies (145A, 145B, 146A, 146B) include a carbide from among silicon carbide and tungsten carbide.

6. The method of fabrication according to any one of claims 1 to 5, wherein the active layer (111, 112, 113) comprises gallium nitride.

7. The method of fabrication according to any one of claims 1 to 6, wherein the active part (115) of the semiconducting structure (100) is a diode, the first and second connection zones corresponding to the metallic contacts (122A, 122B, 123A, 123B) of the anode and cathode of said diode, respectively.

8. The method of fabrication of a semiconducting structure (100) according to claim 7, wherein the active layer comprises:
- a first active sub-layer (111) with a first type of conductivity, the second connection zone being a connection zone of said first active sub-layer (111),
- an active zone (112) adapted to emit light, said active zone (112) preferably comprising at least one quantum well,
- a second active sub-layer (113) with a second type of conductivity opposite the first type of conductivity, the first connection zone being a connection zone of said second active sub-layer (113),

9. Method of fabrication of a semiconducting device (10) comprising a semiconducting structure (100), the method including the following steps:
- formation of a semiconducting structure (100) using a fabrication method according to any one of claims 1 to 8,
- supply of a second support (201) comprising at least a third and a fourth connection zone (222A, 222B, 223A, 223B) corresponding to the first and second connection zones of the semiconducting structure (100), and a first and second bump made of a ductile conducting material (242A, 242B, 243A, 243B) in electrical contact with the third and the fourth connection zones (222A, 222B, 223A, 223B) respectively,
- connection of the first and second connection zones with the third and fourth connection zones (222A, 222B, 223A, 223B) respectively by insertion of the first and second inserts (142A, 142B, 143A, 143B) in the first and second bumps made of a ductile conducting material (242A, 242B, 243A, 243B), respectively.

10. The method of fabrication of a device according to claim 9, wherein the semiconducting structure (100) is a light emitting diode, the second support (201) comprising a control circuit (202) adapted to supply and control said light emitting diode.
